# EUROPEAN PATENT APPLICATION

(11) **EP 4 617 935 A1**
(43) Date of publication of application: **17.09.2025**
(21) Application number: 25386016.7
(22) Date of filing: 10.03.2025
(51) Int. Cl.: G06F 30/13, G06F 30/27, G06N 5/02, G06N 5/022

(54) **KNOWLEDGE GRAPH (KG) CENTRIC DECISION SUPPORT FOR GREEN BUILDING NEIGHBORHOOD RENOVATION SCENARIO MODELING**

(30) Priority: 14.03.2024 GR 20240100193
(71) Applicant: TECHNICAL UNIVERSITY OF CRETE, 73100 Chania, Crete (GR)
(72) Inventor: LYGERAKIS, Filippos, 56429 Thessaloniki (GR); KAMPELIS, Nikolaos, 73100 Chania (GR); KOLOKOTSA, Dionysia, 73133 Chania (GR)
(74) Representative: Panagiotidou, Effimia

(57) **Abstract**

Knowledge graph (KG) centric decision support for GBN renovation scenario modeling includes populating a KG with different data pertaining to characteristics of different buildings in an GBN according to data type conforming to an ontology for the KG so that the KG associates different nodes corresponding to different ones of the data according linking relationships for the different nodes. KG enhancement queries are then executed against the KG to generate additional ones of the linking relationships. Yet further, different renovation scenario data structures are generated for one of the different buildings in the GBN by extracting from the KG different collections of interrelated characteristics for the one of the different buildings in the GBN and applying different modifications to one or more of the characteristics across different scenario data structures. Finally, one or more selected ones of the scenarios data structures uploads to a communicatively coupled digital twin decision support system.

## Description

### STATEMENT OF GOVERNMENTALLY SPONSORED RESEARCH

The project leading to this application has received funding from the European Union's Horizon 2020 research and innovation programme under grant agreement No 101037075 (Grant Agreement, Article 27.3 Information on EU funding).

### BACKGROUND OF THE INVENTION

### Field of the Invention

The present invention relates to the technical field of building performance modeling and more particularly to decision support in scenario modeling green building neighborhood renovations.

### Description of the Related Art

The creation and lifecycle of a building refers to the erection of a building structure with construction materials such as concrete, wood, steel and glass, the outfitting of the building with electrical, plumbing and mechanical systems such as heating ventilation and cooling (HVAC) systems and the maintenance of those systems. Part and parcel of the lifecycle of the building is the periodic renovation of the building to replace worn elements of the building and to install new systems and materials into the building not available at the time of the construction of the building. Of course, the choice to renovate a building results from the desire to render the building energy efficient in order to reduce the operating costs of the building.

In this regard, green building is the practice of creating structures and using processes that are environmentally responsible and resource-efficient throughout the lifecycle of the building from siting to design, construction, operation, maintenance, renovation and deconstruction. The practice of green building expands and complements the classical building design concerns of economy, utility, durability, and comfort. Green building is also known as a sustainable or high-performance building. As an extension of

### STATEMENT OF GOVERNMENTALLY SPONSORED RESEARCH

The project leading to this application has received funding from the European Union's Horizon 2020 research and innovation programme under grant agreement No 101037075 (Grant Agreement, Article 27.3 Information on EU funding).

### BACKGROUND OF THE INVENTION

### Field of the Invention

The present invention relates to the technical field of building performance modeling and more particularly to decision support in scenario modeling green building neighborhood renovations.

### Description of the Related Art

The creation and lifecycle of a building refers to the erection of a building structure with construction materials such as concrete, wood, steel and glass, the outfitting of the building with electrical, plumbing and mechanical systems such as heating ventilation and cooling (HVAC) systems and the maintenance of those systems. Part and parcel of the lifecycle of the building is the periodic renovation of the building to replace worn elements of the building and to install new systems and materials into the building not available at the time of the construction of the building. Of course, the choice to renovate a building results from the desire to render the building energy efficient in order to reduce the operating costs of the building.

In this regard, green building is the practice of creating structures and using processes that are environmentally responsible and resource-efficient throughout the lifecycle of the building from siting to design, construction, operation, maintenance, renovation and deconstruction. The practice of green building expands and complements the classical building design concerns of economy, utility, durability, and comfort. Green building is also known as a sustainable or high-performance building. As an extension of green buildings, a green building neighborhood (GBN) includes a set of green buildings integrated at delimited area or district level with green energy and green mobility management and appropriate infrastructure in order to maximize the economic and social co-benefits considering a district profile (population size, socio-economic structure, and geographical and climate characteristics). Delivered in the right way, GBN infrastructure is a key enabler of inclusive growth, can improve the accessibility of housing and amenities, reduce poverty and inequality, widen access to jobs and education, make communities more resilient to climate change, and promote public health and wellbeing.

Planning building renovations of a building or part of a building or a neighborhood including several buildings, other facilities, outdoor construction elements or systems in a GBN is not a task to be taken lightly. The variables of building and neighborhood characteristics are complex and changes to different characteristics of the building and neighborhood during a proposed renovation can achieve different degrees of optimization. Thus, simulating different scenarios of green building renovation can be helpful. However, simulating a single scenario of a green building renovation can be a daunting task, manually intensive and is dependent upon the characteristics manually specified for the subject building. As such, critical characteristics of the building for which optimizations can be simulated in a renovation scenario to produce impactful improvements can be lost for failure to recognize the critical characteristic in the first instance.

### BRIEF SUMMARY OF THE INVENTION

Embodiments of the present invention address technical deficiencies of the art in respect to modeling prospective renovations to a building, or part of a building, or neighborhood including several buildings, other facilities, outdoor construction elements or systems, referred to hereinafter collectively as a "building". To that end, embodiments of the present invention provide for a novel and non-obvious method for knowledge graph (KG) centric decision support building renovation scenario modeling. Embodiments of the present invention also provide for a novel and non-obvious computing device adapted to perform the foregoing method. Finally, embodiments of the present invention provide for a novel and non-obvious data processing system incorporating the foregoing device in order to perform the foregoing method.

In one embodiment of the invention, a method for knowledge graph (KG) centric decision support for building renovation scenario modeling includes populating a KG with different data pertaining to characteristics of different buildings in an neighborhood such as a GBN according to data type conforming to an ontology for the KG, so that the KG associates different nodes corresponding to different ones of the data according linking relationships for the different nodes. The method additionally includes executing KG enhancement queries against the KG to generate additional ones of the linking relationships. The method yet further includes generating different renovation scenario data structures for one or more of the different buildings in the neighborhood by extracting from the KG different collections of interrelated ones and applying different modifications to one or more of the characteristics across different ones of the scenario data structures. Finally, the method includes uploading a selected one of the scenario data structures in a communicatively coupled digital twin decision support system.

Aspects of the embodiment include variations on the different data which may include alone or in combination:
- The different data is extracted for sensor data sensed within the different buildings and other facilities (including enclosed or outdoor) of the neighborhood.
- The different data includes building construction materials and components for the buildings and other facilities of the neighborhood.
- The different data includes mechanical and electrical systems for the different buildings and other facilities of the neighborhood.
As well, in one aspect of the embodiment, at least a portion of the KG is processed in a graph neural network based recommendation system that has been trained to provide recommendations about one or more of the selected scenario data structures.

In another embodiment of the invention, a data processing system adapted for KG centric decision support for a building renovation scenario modeling includes a host computing platform of one or more computers, each with memory and one or more processing units including one or more processing cores, a KG stored in the memory and including different data pertaining to characteristics of different buildings in a neighborhood such as a GBN according to data type conforming to an ontology for the KG, the KG associating different nodes corresponding to different ones of the data according linking relationships for the different nodes, the KG receiving KG enhancement queries so as to generate additional ones of the linking relationships. The system also includes a digital twin decision support system coupled to the host computing platform. Finally, the system includes a scenario selection module.

The module includes computer program instructions enabled, while executing in the memory of at least one of the processing units of the host computing platform, to generate different renovation scenario data structures for one of the different buildings in the neighborhood by extracting from the KG different collections of interrelated ones of the characteristics for the one of the different buildings in the neighborhood and applying different modifications to one or more of the characteristics across different ones of the scenario data structures. The program instructions additionally upload or more selected ones of the scenarios data structures in the digital twin decision support system. In this way, the technical deficiencies of the traditional building renovations modeling are overcome owing to the dynamic ability of the KG to support changes in the characteristics of the buildings for which renovations are to be modeled, and to the embedded artificial intelligence including the GNN in recognizing and recommending appropriate scenarios for modeling the renovation of a specific building based upon the characteristics of the building in the KG.

Additional aspects of the invention will be set forth in part in the description which follows, and in part will be obvious from the description, or may be learned by practice of the invention. The aspects of the invention will be realized and attained by means of the elements and combinations particularly pointed out in the appended claims. It is to be understood that both the foregoing general description and the following detailed description are exemplary and explanatory only and are not restrictive of the invention, as claimed.

### BRIEF DESCRIPTION OF THE SEVERAL VIEWS OF THE DRAWINGS

The accompanying drawings, which are incorporated in and constitute part of this specification, illustrate embodiments of the invention and together with the description, serve to explain the principles of the invention. The embodiments illustrated herein are presently preferred, it being understood, however, that the invention is not limited to the precise arrangements and instrumentalities shown, wherein:
Figure 1 is a pictorial illustration reflecting different aspects of a process of for KG centric decision support for GBN renovation scenario modeling;
Figure 2 is a block diagram depicting a data processing system adapted to perform one of the aspects of the process of Figure 1; and,
Figure 3 is a flow chart illustrating one of the aspects of the process of Figure 1.

### DETAILED DESCRIPTION OF THE INVENTION

Embodiments of the invention provide for KG centric decision support for GBN renovation scenario modeling. In accordance with an embodiment of the invention, different characteristics of different buildings in a GBN are captured and submitted as nodes in a KG, including structural features and installed systems, sensor acquired data, data sourced from architectural plans for the buildings such as building and neighborhood materials, and manually input data. The KG is then subjected to data discovery and enhancement to refine the KG. Different queries to the KG are then performed to extract different data points for different scenarios for the renovation of one of the buildings resulting in a modification to the structural features or installed systems. One or more of the scenarios may then be selected for uploading to a digital twin decision support system. As an option, a network reference to the KG may be provided to a graph neural network trained to associate a corresponding building to a known building and one or more corresponding scenarios are selected for uploading to the digital twin decision support system.

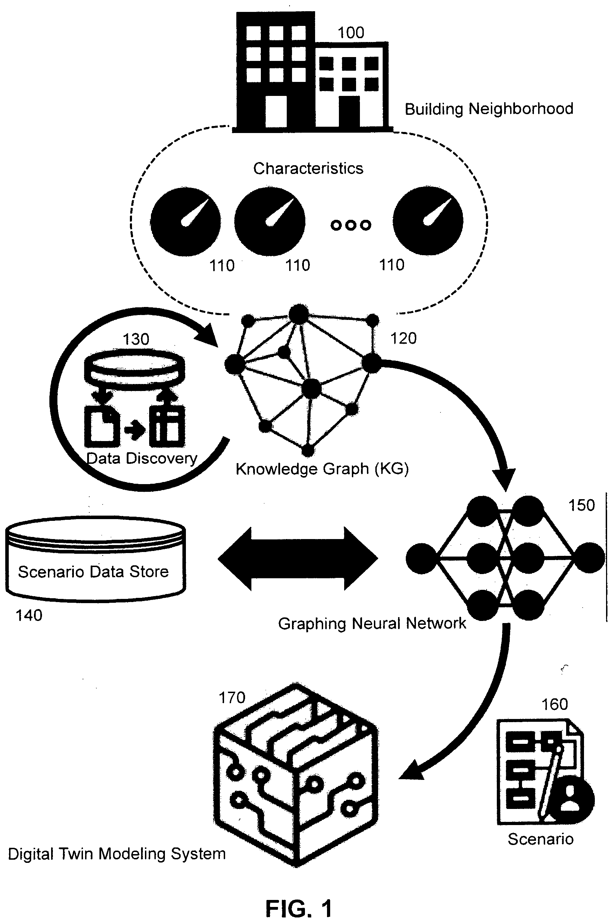

In illustration of one aspect of the embodiment, Figure 1 pictorially shows a process for KG centric decision support for GBN renovation scenario modeling. As shown in Figure 1, different characteristics 110 of different buildings in a GBN 100 are extracted and/or determined and included in a KG 120 for the GBN 100. Data and knowledge discovery and extraction 130 is then performed upon the KG 120 in order to recognize different previously unrecognized relationships between the different characteristics 110. A reference to the KG 120 is then provided to a graph neural network 150 in order to correlate the KG 120 with one or more previously stored scenarios of renovation 160 stored in a data store of scenarios 140. Finally, the previously stored scenarios of renovation 160 is uploaded to a digital twin modeling system 170 in order to model the previously stored scenarios of renovation 160.

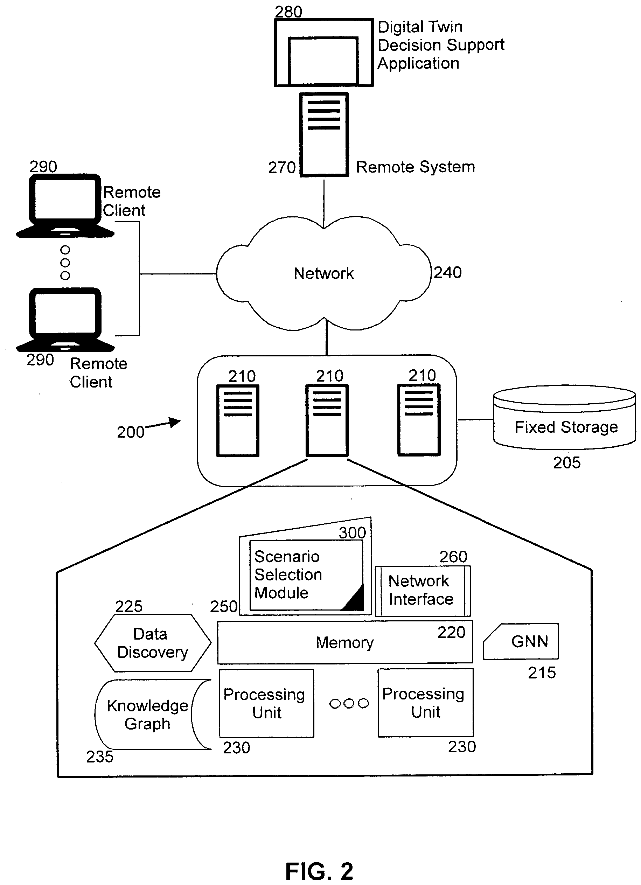

Aspects of the process described in connection with Figure 1 can be implemented within a data processing system. In further illustration, Figure 2 schematically shows a data processing system adapted to perform for KG centric decision support for GBN renovation scenario modeling. In the data processing system illustrated in Figure 1, a host computing platform 200 is provided. The host computing platform 200 includes one or more computers 210, each with memory 220 and one or more processing units 230. The computers 210 of the host computing platform 200 (only a single computer shown for the purpose of illustrative simplicity) can be co-located within one another and in communication with one another over a local area network, or over a data communications bus, or the computers can be remotely disposed from one another and in communication with one another through network interface 260 over a data communications network 240.

Importantly, a KG 225 is stored within the memory 220 of the host computing platform 220. In particular, the KG 235 stores therein different data pertaining to characteristics of different buildings in an GBN according to data type conforming to an ontology for the KG 235. In this regard, the data can include sensor data sensed within the building including temperature, humidity, pressure, air flow, sound level and the like. The data further can include a manifest of building components and materials data sourced from the construction documents of the building, geolocation data, operational energy data and weather data. The KG 235 further associates different nodes corresponding to different ones of the data according linking relationships for the different nodes. As well, the KG 235 receives KG enhancement queries from data and knowledge discovery and extraction process 225 in order to generate additional linking relationships for the nodes of the KG 235.

A digital twin decision support application 280 executing in a host remote computing system 270 is communicatively coupled to the host computing platform 200 from over the data communications network 240. The digital twin decision support application 280 is adapted to receive one or more scenarios of a specific configuration of a building including construction materials, installed systems and operational settings of the installed systems. The digital twin decision support application 280 is further enabled to construct a digital twin from the received scenario and to model the performance of the building in consequence of the specific configuration.

The host computing platform 200 additionally is communicatively coupled over data communications network 240 to one or more remote clients 290. Each of the remote clients 290 includes a user interface through which end user access to the applications executing in the host computing platform 200 may be provided. In this regard, the host computing platform 200 includes a computing device 250 including a non-transitory computer readable storage medium which may be accessed by the processing units 230 of one or more of the computers 210. The computing device stores 250 thereon or retains therein a program module 300 that includes computer program instructions which when executed by one or more of the processing units 230, performs a programmatically executable process for KG centric decision support for GBN renovation scenario modeling.

Specifically, the program instructions during execution submit a network reference to the KG 235 to GNN 215 so as to identify within fixed storage 205, a scenario corresponding to a building with building characteristics mapping to those of the KG 235. Thereafter, the identified scenario is submited to GNN 215. The GNN 215 is a neural network operable upon a selected scenario from the knowledge graph and trained to correlate the data encapsulated within the selected scenario with an optimized set of characteristics for a subject building so as to tune the scenario. The program instructions then submit the tuned scenario to the digital twin decision support application 280 from over the data communications network 240 in order to permit the digital twin decision support application 280 to construct a digital twin of the subject building and to model the performance of the subject building.

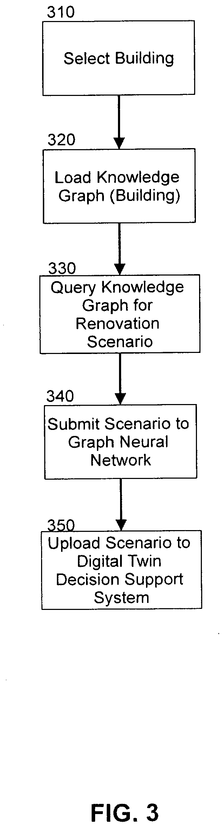

In further illustration of an exemplary operation of the module, Figure 3 is a flow chart illustrating one of the aspects of the process of Figure 1. Beginning in block 305, a building in a GBN is selected for modeling according to a relevant scenario of renovation. In block 320, a neighborhood-level KG is loaded into memory from a file storage location according to a network address. In block 330, the KG is queried for a scenario with the characteristics of a subject building. Then, the scenario received from the KG is submitted to the GNN in order to receive from the GNN in block 340, a tuned form of the scenario pertinent to the characteristics of the building evident from the KG and tuned by the GNN. Finally, in block 350 the scenarios are uploaded to the digital twin decision support system from over a data communications network in order to model the performance of the building in light of the scenario.

Of import, the foregoing flowchart and block diagram referred to herein illustrate the architecture, functionality, and operation of possible implementations of systems, methods, and computing devices according to various embodiments of the present invention. In this regard, each block in the flowchart or block diagrams may represent a module, segment, or portion of instructions, which includes one or more executable instructions for implementing the specified logical function or functions. In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

More specifically, the present invention may be embodied as a programmatically executable process. As well, the present invention may be embodied within a computing device upon which programmatic instructions are stored and from which the programmatic instructions are enabled to be loaded into memory of a data processing system and executed therefrom in order to perform the foregoing programmatically executable process. Even further, the present invention may be embodied within a data processing system adapted to load the programmatic instructions from a computing device and to then execute the programmatic instructions in order to perform the foregoing programmatically executable process.

To that end, the computing device is a non-transitory computer readable storage medium or media retaining therein or storing thereon computer readable program instructions. These instructions, when executed from memory by one or more processing units of a data processing system, cause the processing units to perform different programmatic processes exemplary of different aspects of the programmatically executable process. In this regard, the processing units each include an instruction execution device such as a central processing unit or "CPU" of a computer. One or more computers may be included within the data processing system. Of note, while the CPU can be a single core CPU, it will be understood that multiple CPU cores can operate within the CPU and in either instance, the instructions are directly loaded from memory into one or more of the cores of one or more of the CPUs for execution.

Aside from the direct loading of the instructions from memory for execution by one or more cores of a CPU or multiple CPUs, the computer readable program instructions described herein alternatively can be retrieved from over a computer communications network into the memory of a computer of the data processing system for execution therein. As well, only a portion of the program instructions may be retrieved into the memory from over the computer communications network, while other portions may be loaded from persistent storage of the computer. Even further, only a portion of the program instructions may execute by one or more processing cores of one or more CPUs of one of the computers of the data processing system, while other portions may cooperatively execute within a different computer of the data processing system that is either co-located with the computer or positioned remotely from the computer over the computer communications network with results of the computing by both computers shared therebetween.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description but is not intended to be exhaustive or limited to the invention in the form disclosed. Many modifications and variations will be apparent to those of ordinary skill in the art without departing from the scope and spirit of the invention. The embodiment was chosen and described in order to best explain the principles of the invention and the practical application, and to enable others of ordinary skill in the art to understand the invention for various embodiments with various modifications as are suited to the particular use contemplated.

Having thus described the invention of the present application in detail and by reference to embodiments thereof, it will be apparent that modifications and variations are possible without departing from the scope of the invention defined in the appended claims as follows:

## Claims

1. A method for knowledge graph (KG) centric decision support for green building neighborhood (GBN) renovation scenario modeling comprising:
populating a KG with different data pertaining to characteristics of different buildings in an GBN according to data type conforming to an ontology for the KG, the KG associating different nodes corresponding to different ones of the data according linking relationships for the different nodes;
executing KG enhancement queries against the KG to generate additional ones of the linking relationships;
generating different renovation scenario data structures for one of the different buildings in the GBN by extracting from the KG different collections of interrelated ones of the characteristics for the one of the different buildings in the GBN and applying different modifications to one or more of the characteristics across different ones of the scenario data structures; and,
uploading selected ones of the scenarios data structures in a communicatively coupled digital twin decision support system.

2. The method of claim 1, wherein the different data is extracted for sensor data sensed within the different buildings of the GBN.

3. The method of claim 1, wherein the different data includes building construction materials for the buildings of the GBN.

4. The method of claim 1, wherein the different data includes mechanical systems for the different buildings of the GBN.

5. The method of claim 1, wherein at least a portion of the KG is processed in a graph neural network predictor to predict one or more selected ones of the scenarios data structures.

6. A data processing system adapted for knowledge graph (KG) centric decision support for green building neighborhood (GBN) renovation scenario modeling, the system comprising:
a host computing platform comprising one or more computers, each with memory and one or processing units including one or more processing cores;
a KG stored in the memory and comprising different data pertaining to characteristics of different buildings in an GBN according to data type conforming to an ontology for the KG, the KG associating different nodes corresponding to different ones of the data according linking relationships for the different nodes, the KG receiving KG enhancement queries so as to generate additional ones of the linking relationships;
a digital twin decision support system coupled to the host computing platform; and,
a scenario selection module comprising computer program instructions enabled while executing in the memory of at least one of the processing units of the host computing platform to perform:
generating different renovation scenario data structures for one of the different buildings in the GBN by extracting from the KG different collections of interrelated ones of the characteristics for the one of the different buildings in the GBN and applying different modifications to one or more of the characteristics across different ones of the scenario data structures; and,
uploading one or more selected ones of the scenarios data structures in the digital twin decision support system.

7. The system of claim 6, wherein the different data is extracted for sensor data sensed within the different buildings of the GBN.

8. The system of claim 6, wherein the different data includes building construction materials for the buildings of the GBN.

9. The system of claim 6, wherein the different data includes mechanical systems for the different buildings of the GBN.

10. The system of claim 6, wherein at least a portion of the KG is processed in a graph neural network predictor to predict one or more selected ones of the scenarios data structures.

11. A computing device comprising a non-transitory computer readable storage medium having program instructions stored therein, the instructions being executable by at least one processing core of a processing unit to cause the processing unit to perform knowledge graph (KG) centric decision support for green building neighborhood (GBN) renovation scenario modeling, the instructions during execution by the at least one processing core performing the KG centric decision support by:
populating a KG with different data pertaining to characteristics of different buildings in an GBN according to data type conforming to an ontology for the KG, the KG associating different nodes corresponding to different ones of the data according linking relationships for the different nodes;
executing KG enhancement queries against the KG to generate additional ones of the linking relationships;
generating different renovation scenario data structures for one of the different buildings in the GBN by extracting from the KG different collections of interrelated ones of the characteristics for the one of the different buildings in the GBN and applying different modifications to one or more of the characteristics across different ones of the scenario data structures; and,
uploading one or more selected ones of the scenarios data structures in a communicatively coupled digital twin decision support system.

12. The device of claim 11, wherein the different data is extracted for sensor data sensed within the different buildings of the GBN.

13. The device of claim 11, wherein the different data includes building construction materials for the buildings of the GBN.

14. The device of claim 11, wherein the different data includes mechanical systems for the different buildings of the GBN.

15. The device of claim 11, wherein at least a portion of the KG is processed in a graph neural network predictor to predict one or more selected ones of the scenarios data structures.
